# EUROPÄISCHE PATENTANMELDUNG

(11) **EP 3 907 764 A1**
(43) Veröffentlichungstag der Anmeldung: **10.11.2021**
(21) Anmeldenummer: 20173549.5
(22) Anmeldetag: 07.05.2020
(51) Int. Cl.: H01L 31/0232, H01L 31/0304, H01L 31/101, H01L 31/18, H01Q 15/08, H01Q 1/22, G01N 21/3581

(54) **ANORDNUNG FÜR EINE ANTENNE ZUM ERZEUGEN ODER EMPFANGEN VON TERAHERTZ-STRAHLUNG, ANTENNE, TERAHERTZSYSTEM SOWIE VERFAHREN ZUR HERSTELLUNG EINER ANORDNUNG FÜR EINE ANTENNE**

(71) Anmelder: FRAUNHOFER-GESELLSCHAFT zur Förderung der angewandten Forschung e.V., 80686 München (DE)
(72) Erfinder: GLOBISCH, Björn, 10587 Berlin (DE); KOHLHAAS, Robert, 10587 Berlin (DE)
(74) Vertreter: Pfenning, Meinig & Partner mbB

(57) **Zusammenfassung**

Die Erfindung betrifft eine Anordnung (1) für eine Antenne (16, 17) zum Erzeugen oder Empfangen von Terahertz-Strahlung (12), umfassend
- eine photoaktive Schicht (2), welche durch optische Strahlung (11) im Bereich 1200 nm bis 1700 nm aktivierbar ist,
- ein für die optische Strahlung (11) transparentes Substrat (3), auf dem die photoaktive Schicht (2) befestigt ist,
- eine erste haftvermittelnde Schicht (4), wobei die erste haftvermittelnde Schicht (4) zwischen der photoaktiven Schicht (2) und dem Substrat (3) angeordnet ist und beide flächig miteinander verbindet, wobei die erste haftvermittelnde Schicht (4) eine Schichtdicke von höchstens 5 µm aufweist, und
- einen für die optische Strahlung (11) transparenten Träger (5), wobei das Substrat (3) auf dem Träger (5) befestigt ist und zwischen der photoaktiven Schicht (2) und dem Träger (5) angeordnet ist,
wobei das Substrat (3) und der Träger (5) aus einem gleichen Material hergestellt sind.

Außerdem betrifft die Erfindung eine Antenne (16, 17), ein Terahertzsystem (20) sowie ein Verfahren zur Herstellung der genannten Anordnung (1).

## Beschreibung

Die vorliegende Erfindung betrifft eine Anordnung für eine Antenne zum Erzeugen oder Empfangen von Terahertz-Strahlung, eine Antenne zum Erzeugen oder Empfangen von Terahertz-Strahlung, ein Terahertzsystem zum Erzeugen und kohärenten Detektieren von Terahertzstrahlung sowie ein Verfahren zur Herstellung einer Anordnung für eine Antenne zum Erzeugen oder Empfangen von Terahertz-Strahlung.

Als Terahertzstrahlung sei dabei elektromagnetische Strahlung einer Frequenz von zwischen 0,05 THz und 20 THz bezeichnet, wobei die Frequenz typischerweise zwischen 0,1 THz und 10 THz liegt. Für eine elektronische Signalverarbeitung sind diese Frequenzen sehr hoch, verglichen mit den für Photonik typischen Frequenzen dagegen sehr klein, so dass eine Quantenenergie von Terahertzstrahlung noch sehr gering ist. Mit Terahertzstrahlung arbeitende Messsysteme sind daher schwer zu realisieren, weshalb Terahertzstrahlung den letzten Bereich des elektro-magnetischen Spektrums bildet, der für praktische Anwendungen noch nicht in befriedigendem Maß erschlossen ist.

Terahertzsysteme nutzen typischerweise opto-elektronische Halbleiterchips zum Erzeugen und Detektieren von Terahertzstrahlung. Ein Terahertzsystem umfasst dabei gewöhnlich eine Laserlichtquelle und zwei jeweils über einer Lichtleitfaser optisch mit der Laserlichtquelle gekoppelte und durch Licht dieser Laserlichtquelle aktivierbare THz-Antennen, von denen eine erste als Sendeantenne und eine zweite als Empfängerantenne dient. Dabei weisen die THz-Antennen jeweils einen mit Antennenleitern kontaktierten Halbleiterchip auf, der mindestens eine photoempfindliche aktive Schicht mit einer Bandkantenwellenlänge, die größer ist als eine Wellenlänge der Laserlichtquelle, umfasst sowie mindestens eine an die aktive Schicht angrenzende Schicht mit einer Bandkantenwellenlänge, die kleiner ist als die Wellenlänge der Laserlichtquelle. Die Antennenleiter sind dabei typischerweise auf dem jeweiligen Halbleiterchip integriert. Die Laserlichtquelle kann dabei zum Erzeugen kurzer Pulse oder zum Erzeugen von Schwebungssignalen im THz-Bereich durch Überlagern zweier Laserwellen geringfügig unterschiedlicher Wellenlängen ausgebildet sein. Die Wellenlänge einer Laserlichtquelle sei in der vorliegenden Schrift jeweils definiert als Schwerpunkt eines Wellenlängenspektrums des von der Laserlichtquelle erzeugten Lichts.

Mit solchen Terahertzsystemen kann nun Terahertzstrahlung erzeugt und kohärent detektiert werden, indem an die Antennenleiter der Sendeantenne eine Spannung angelegt wird, während die Sendeantenne und die Empfängerantenne gleichzeitig oder mit einstellbarer Verzögerung mit kohärenter Strahlung der Laserlichtquelle aktiviert werden und ein in der Empfängerantenne erzeugter Strom gemessen wird mittels eines mit den Antennenleitern der Empfängerantenne verbundenen Sensors. Um eine zwischen der Sendeantenne und der Empfängerantenne angeordnete Probe zu untersuchen, kann auf diese Weise ein Empfangssignal für verschiedene Verzögerungen einer Lichtlaufzeit zwischen der Laserlichtquelle und der Empfängerantenne oder der Sendeantenne detektiert werden.

Terahertzsysteme dieser Art sind z.B. aus den Druckschriften DE 10 2007 044 839 A1 und DE 10 2010 049 658 A1 bekannt. Durch die Verwendung von Lichtleitfasern zur Verbindung der Laserlichtquelle mit den THz-Antennen lassen sich diese Terahertzsysteme vorteilhaft kompakt, robust und flexibel realisieren.

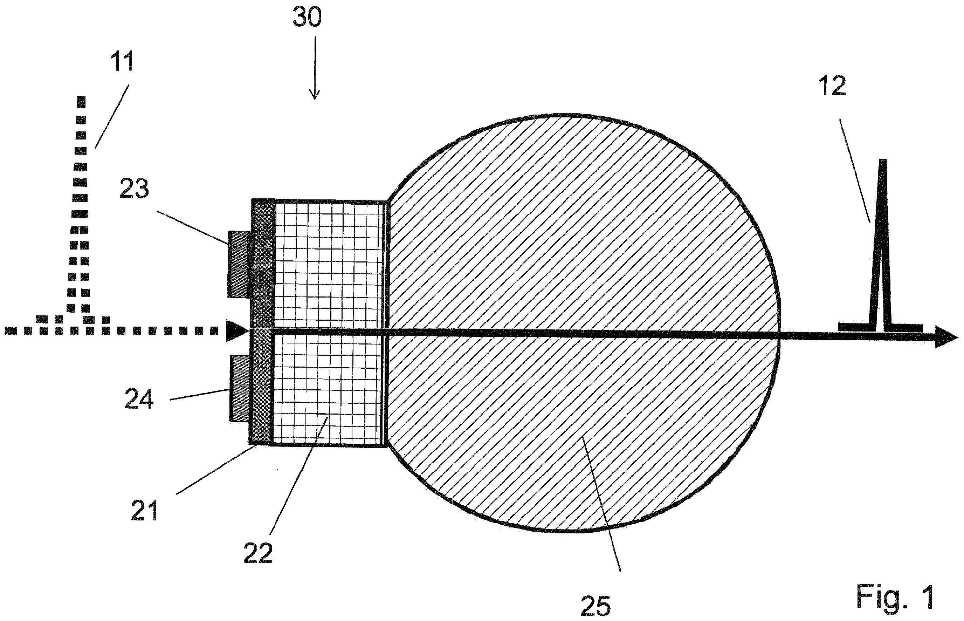

Nachfolgend wird näher auf eine in Fig. 1 gezeigte THz-Antenne gemäß einem Beispiel des Standes der Technik eingegangen. Die THz-Antenne 30 der Fig. 1 umfasst eine photoaktive Schicht 21 mit schneller Ladungsträger-Rekombinationszeit, die durch epitaktisches Wachstum auf einem elektrisch isolierenden Substrat 22 hergestellt wurde. Durch Aufdampf- und Lithographie-Prozesse wird auf der photoaktiven Schicht eine metallische Struktur 23, 24 als THz-Antenne ausgebildet, die beispielsweise in Dipol, Bowtie oder Strip-Line Geometrie ausgebildet sein kann. Die metallische Struktur 23, 24 hat eine Lücke, durch die ein kurzer (fs-Bereich) Lichtpuls 11 auf die photoaktive Schicht 21 gerichtet werden kann. Die Antenne 20 der Fig. 1 ist beispielhaft als THz-Sender ausgebildet. Im THz-Sender 20 wird an die metallische Struktur 23, 24 eine Spannung angelegt. Durch Anregung mit dem Lichtpuls 11 werden in der photoaktiven Schicht Photoladungsträger erzeugt und im elektrischen Feld stark beschleunigt, wodurch elektromagnetische Strahlung im THz-Bereich (0,1 - 10 THz) erzeugt wird. Wegen des großen Brechungsindex-Sprunges zu Luft breitet sich die Strahlung bevorzugt im Halbleitermaterial der Schicht 21 und des Substrats 22 aus. Zur besseren Auskopplung der THz-Welle in Luft wird der Antennen-Chip bzw. das Substrat 22 auf der planen Fläche einer hyper-hemisphärischen Si-Linse 25 aus hochreinem Si mit hoher THz-Transparenz angebracht.

Der THz-Empfänger sieht im Prinzip baugleich aus. Hier wird aber keine Spannung angelegt. Stattdessen wird im THz-Empfänger der durch empfangene THz-Strahlung und angeregte Photoladungsträger bewirkte Photostrom gemessen. Ein Photostrom fließt aber nur, wenn - zeitgleich - durch die empfangene THz-Strahlung eine Spannung angelegt wird und durch den Lichtpuls die Photoleitung bewirkt wird. In einem THz Time-Domain System wird deshalb in einem der Strahlengänge eine Verzögerungsleitung angebracht, durch die die zeitliche Lage von empfangener THz Strahlung und abtastendem fs-Lichtpuls variiert werden kann. Es wird so eine "kohärente" Detektion bewirkt, und mit hoher Empfindlichkeit und hohem Geschwindigkeitspotenzial werden Amplitude und Phase der THz-Welle in einem pump-probe Verfahren abgetastet.

Erste THz-System nutzten eine Anregungswellenlänge bei 800 nm, da hier leistungsstarke Puls-Laser mit fs-kleiner Pulsbreite und Photoleiter aus "lowtemperature" gewachsenem LT-GaAs auf GaAs-Substrat mit sehr schneller Rekombinationszeit zur Verfügung standen.

Neue Systeme nutzen vielfach Anregungswellenlängen bei 1300 nm und bei 1550 nm, da hier viele Komponenten aus Entwicklungen für die optische Telekommunikationstechnik zur Verfügung stehen. Femtosekunden Faser-Laser bei 1550 nm sind mittlerweile kostengünstig und wartungsfrei, und Glasfasern erlauben flexible Verbindungen vom Laser zu beweglichen Sende- und Detektions-Köpfen. Das bietet erhebliche Vorteile für den industriellen Einsatz der THz Sensorik. Da GaAs jedoch bei 1550 nm nicht absorbiert, mussten aber zunächst schnelle Photoleiter für diesen Wellenlängenbereich entwickelt werden. Diese sind nun vorhanden, basierend auf InGaAs-, InGaAsP-, InAlAs-, InGaAlAsP- und InGaAlAs-Schichten, welche jeweils epitaktisch gitterangepasst auf einem InP-Substrat gewachsen werden.

Eine typische Dicke der Photoleiterschichten liegt im Bereich 1-2 µm, was in etwa der Eindringtiefe (1/e) des anregenden Lichtes entspricht. Dickere Schichten erfordern mehr Aufwand beim epitaktischen Wachsen. Es werden allerdings kaum mehr Photoladungsträger erzeugt. Dagegen steigt der Hintergrund-Dunkelstrom (Rauschen) unvorteilhaft an. Außerdem wird durch lange Wege vom Anregungsort tief in der Schicht zu Oberflächenkontakten das Zeitverhalten (Bandbreite der Detektion) ungünstig beeinflusst.

In den vorteilhaft dünnen Schichten wird die anregende optische Strahlung nicht komplett absorbiert. Bei 800 nm Systemen ist das kein Problem, denn das GaAs-Substrat absorbiert hier auch, und bei einer typischen Substratdicke von 300 - 500 µm wird die anregende optische Strahlung komplett aus dem System entfernt. Das InP-Substrat ist jedoch typischerweise für Wellenlängen oberhalb von 1000 nm transparent. Restlicht hinter der photoaktiven Schicht (also hinter dem Photoleiter), welches nicht durch die photoaktive Schicht absorbiert wurde, wird somit nicht im nachgeschalteten Substrat absorbiert, sondern es verbleibt im System und kann dieses in seiner Funktion beeinträchtigen. Kritisch ist insbesondere, wenn Restlicht-Pulse die Sende- oder Empfangsantenne mit falscher Zeitlage aktivieren. So kann der die SendeAntenne anregende Laserpuls über die THz-Abbildungsoptiken auch die Empfänger-Antenne erreichen. Zur Abblockung dieses Weges werden im Stand der Technik z.B. Lichtfilter im THz-Strahlengang eingesetzt. Was mit diesen externen Filtern jedoch nicht erreicht werden kann, ist die Abblockung von Störpulsen, die durch interne Reflexionen an Grenzflächen innerhalb der THz-Antennen entstehen.

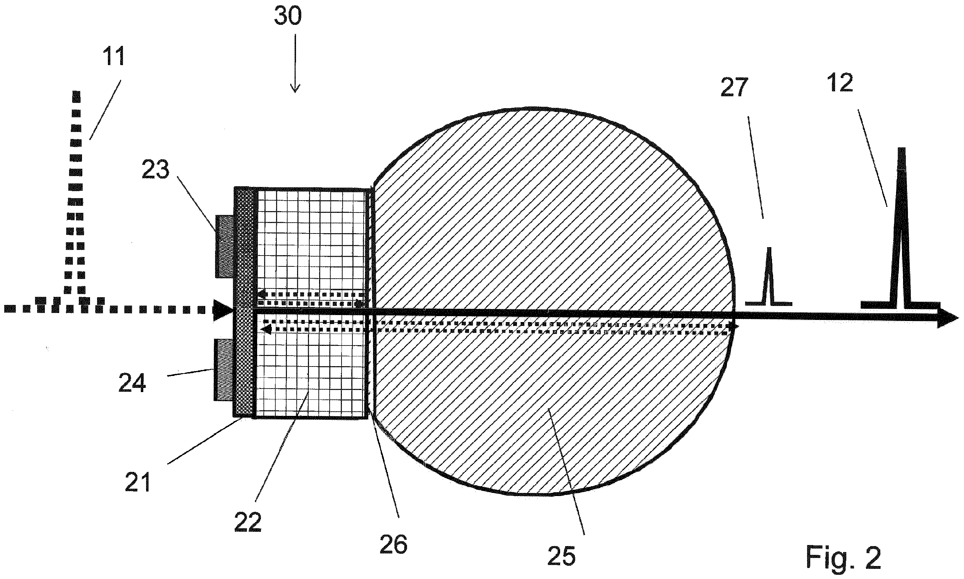

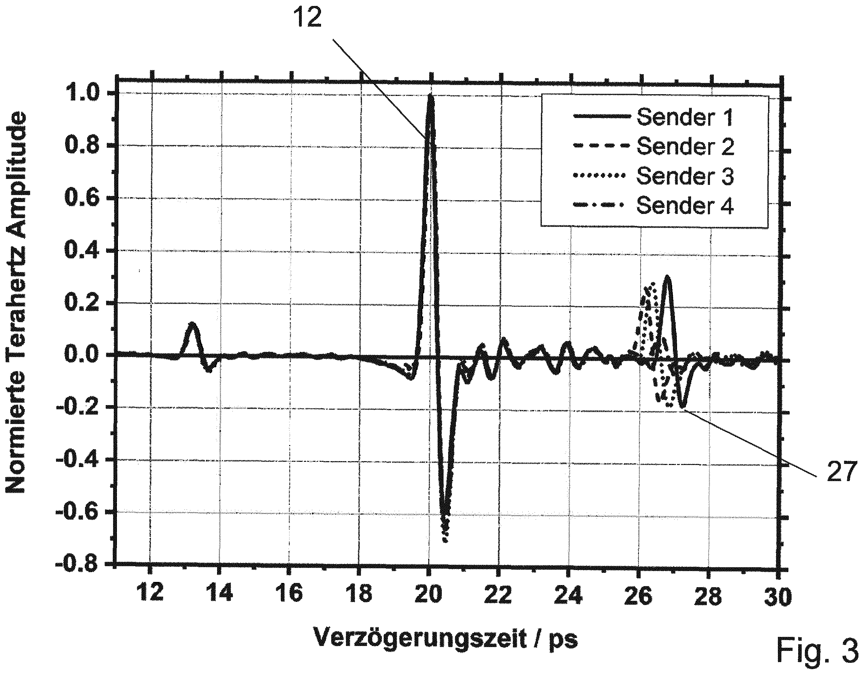

Derartige interne optische Reflexionen sind durch die gestrichelten Linien in Fig. 2 angedeutet, wobei die Fig. 2 einen ähnlichen Aufbau wie die Fig. 1 zeigt. Wenn diese Laser-Pulse mit ungünstiger Zeitverzögerung ein zweites Mal die Pholeiterschicht anregen und so dort "Echo"-THz-Pulse 27 erzeugen, dann kann dies die Funktion eines THz-Sensorsystems erheblich beeinträchtigen. Messungen eines Systems im Stand der Technik zeigen diese Störpulse sehr deutlich, vgl. THz-Echo-Pulse 27 der Fig. 3. Es wäre somit vorteilhaft, wenn diese durch optische Reflexionen verursachten THz-Echo-Pulse 27 vermieden oder zumindest reduziert werden können, da Echo-Pulse selbst kleinster Amplituden Messungen signifikant stören können.

Nachstehend soll die Störung durch optische Reflexionen abgeschätzt werden. Hierbei ist zu berücksichtigen, dass bei der Bewertung einer Störung durch optische Reflexionen nicht nur die Amplitude eingeht, sondern auch die Zeitlage eines Echopulses, und zwar
1. im Vergleich zur räumlichen Ausdehnung des optischen Pulses und
2. in Bezug auf die Zeitlage des Messfensters.

Zunächst wird beispielhaft die Störung des Echopulses anhand der räumlichen Ausdehnung des optischen Pulses und an nahen Grenzflächen abgeschätzt. Ein typischerweise eingesetzter Laser-Puls einer Zeitbreite von 100 femtoSekunden hat - abgeleitet aus der Lichtgeschwindigkeit - eine räumliche Breite von 30 µm in Luft und von ca. 10 µm in Halbleitern mit einem Brechungsindex nahe bei n=3 (InP: 3,167 bei einer Wellenlänge von 1550 nm). Bei einer Photoleiter-Schichtdicke von typisch 2-3 µm regt also ein räumlich 10 µm ausgedehnterer Puls die Photoleitung an. Reflexionen an der Photoleiter-Grenzfläche oder nahe daran werden nicht als separates Echo wahrgenommen, sondern werden Teil eines etwas breiteren Anregungspulses. Eine freie Photoleiterschicht würde also trotz großer Brechungsindexsprünge an den Grenzflächen keine Echos erzeugen. Allerdings wäre eine solche Schicht mechanisch nicht hinreichend stabil.

In Bezug auf die Zeitlage des Messfensters und auf ferner liegende Grenzflächen kann die Störung des Echopulses folgendermaßen abgeschätzt werden. Reflexionen an weiter entfernten Grenzflächen führen zu Echo-Pulsen typischerweise weit außerhalb des Messfensters. So haben die Reflexion an der Außenseite einer Si-Linse (vgl. Linse 25 der Fig. 1) gegen Luft - wegen des hohen Brechungsindex-Sprunges Δn von etwa 2,5 (Brechungsindex von Si: 3,478 bei einer Wellenlänge von 1550 nm, Brechungsindex von Luft: ca. 1 bei einer Wellenlänge von 1550 nm) - eine sehr hohe Amplitude. Der Abstand zwischen der Photoleiterschicht und der Außenseite der Si-Linse ist mit 7,35 mm recht groß, wobei hier von einer Dicke des InP-Substrats von etwa 350 µm und einer Dicke der Si-Linse von etwa 7 mm ausgegangen wurde. Da der Echo-Puls diesen Weg zwei Mal durchläuft beträgt die Zusatz-Laufstrecke gegen den Original-Puls also etwa 14,7 mm. Berücksichtigt man noch den Brechungsindex von ca. 3,4, so ergibt sich sogar eine optische Zusatz-Wegstrecke von ca. 50 mm und somit eine Verzögerung des Echo-Pulses von ca. 150 ps. Damit liegen diese Echo-Pulse außerhalb der typischen Messfenster und stören die Messungen in der Regel nicht.

Die Grenzfläche zwischen InP-Substrat (n = 3,167 bei 1550 nm) und Si-Linse (n = 3,478 bei 1550 nm) weist bei bündigem Kontakt einen Brechungsindexsprung von Δn = 0.311 auf. Dieser flächenhaft bündige Kontakt ist aber - insbesondere wegen der begrenzten Planarität des spröden InP-Substrats - schwer zu erreichen. Bildet sich als Folge in Teilbereichen ein Luftspalt zwischen InP und Si aus, dann ist an den Halbleiter-Luft Grenzflächen mit wesentlich höheren Reflexionen zu rechnen. Dabei spielt aber auch die Breite des Luftspaltes relativ zur Wellenlänge eine Rolle. Bei einer Terahertz-Welle mit Wellenlängen im 100 µm - Bereich (3 THz) ragt die nur relativ langsam abklingende Welle über einen sub-µm-Spalt hinaus ins zweite Halbeitermaterial hinein und breitet sich dort aus, sodass eine hohe Reflexion sich hier noch nicht ausbilden kann. Für den anregenden Laserpuls mit einer Wellenlänge von z.B. 1,5 µm aber bildet sich bereits bei einer Spaltbreite von 0,75 µm (halbe Wellenlänge) die erste Resonatormode höchster Reflexion aus, und der Anstieg der Reflexion setzt deshalb schon bei kleineren Spaltbreiten ein. Kleine sub-µm Luftspalte wirken sich also wegen der um Größenordnungen unterschiedlichen Wellenlängen auf THz-Wellen kaum aus, während der optische Anregungspuls eine hohe Reflexion erfährt.

In den oben betrachteten THz-Systemen mit langwelliger Anregung bei 1,5 µm Wellenlänge von epitaktischen Schichten auf für diese Wellenlänge transparentem InP-Substrat sind es zusammenfassend die optischen Reflexionen an der Grenzfläche zwischen InP-Substrat und der Si-Linse (vgl. Grenzfläche 26 in Fig. 2), die zu störenden Echo-Pulsen führen, wobei die Echopulse die photoaktive Schicht verzögert ein zweites Mal treffen und anregen. Der THz-Sender emittiert dadurch Echo-Pulse, und im Empfänger wird das empfangene THz-Signal ein zweites Mal abgetastet. Daher entstehen zeitversetzte Replika der THz-Signalmuster.

Zur Zeitlage der optischen Reflexion an der Grenzfläche InP-Substrat zu Si-Linse können z.B. folgende Aussagen getroffen werden. Das in den Figuren 1 und 2 gezeigte InP-Substrat hat eine Dicke von typischerweise 350 µm, Hin- und Rückweg sind also 700 µm. Rechnet man über den Brechungsindex die Lichtgeschwindigkeit in InP ein, ein so ergibt sich eine Verzögerung des Echos zum Hauptpuls von ca. 7 ps. Eine derartige Verzögerung der Echo-Pulse ist messbar und in Fig. 3 deutlich erkennbar.

Will man im Vergleich z.B. eine Probe mit einer Mehrschicht-Struktur mit Schichtdicken im einige 100 µm-Bereich vermessen, so liegen die an Vorseite und Rückseite der Schicht reflektierten Pulse (Hin- und Rückweg 200 µm) um (bei einem für die Probe angenommenen Brechungsindex von 1,5) auch einige ps auseinander. Berücksichtigt man die Mehrschicht-Struktur der Probe, die Breite der THz-Pulse, und die geringe Amplitude der Reflexion an den inneren Lack-Grenzflächen, dann wird deutlich, dass Echopulse dieser Zeitlage die Messgenauigkeit erheblich beeinträchtigen.

Die Reflexionen zwischen dem InP-Sustrat und der Si-Linse sind tatsächlich die kritischen Reflexionen, wie auch Messungen bei Einsatz von THz-Antennen in einem Time-Domain System zeigen (vgl. Fig. 3). Beobachtet werden Vor- und Nach-Pulse mit einem Abstand von ca. 7 ps zum Hauptpuls. Wie oben beschrieben, entsprechen diese 7 ps genau der Zeitverzögerung von Echo-Pulsen durch Reflexion des Laserpulses an der Grenzfläche zwischen InP-Substrat und Si-Linse. Durch Dickenschwankungen des InP-Substrats (nominell 350 µm) variiert bei Vergleich verschiedener THz-Sende-Chips die Zeitlage des einen Pulses etwas.

Die Echo-Pulse auf der anderen Zeitachsen-Seite (vgl. Fig. 3) sind durch die Reflexionen des fs-Lasers im THz Empfänger bedingt. Der Empfänger ist in allen Messungen gleich, weshalb die zugehörigen Echo-Pulse auch gut übereinanderliegen. Prinzipiell können diese Echo-Pulse in einem festen Mess-System also herausgerechnet werden. Kritisch wird es aber, wenn ein schwaches Messsignal nahe bei einem der Echo-Pulse liegt. Dies soll an einem wichtigen Anwendungsbeispiel erläutert werden.

Wichtige Anwendungsgebiete ergeben sich daraus, dass THz-Strahlung (0,1 THz bis 30 THz) viele dielektrische Materialien wie Kunststoffe, Lacke und Papier durchdringen kann, die für sichtbares Licht undurchsichtig sind. Dies schafft Einsatzmöglichkeiten in der zerstörungsfreien Materialprüfung. Gefragt ist z.B. die Messung der Dicke einzelner Lagen von Plastik-Materialien in Verbund-Werkstoffen, bevorzugt kontaktfrei schon beim Herstellungs-Prozess (z.B. Extrusion).

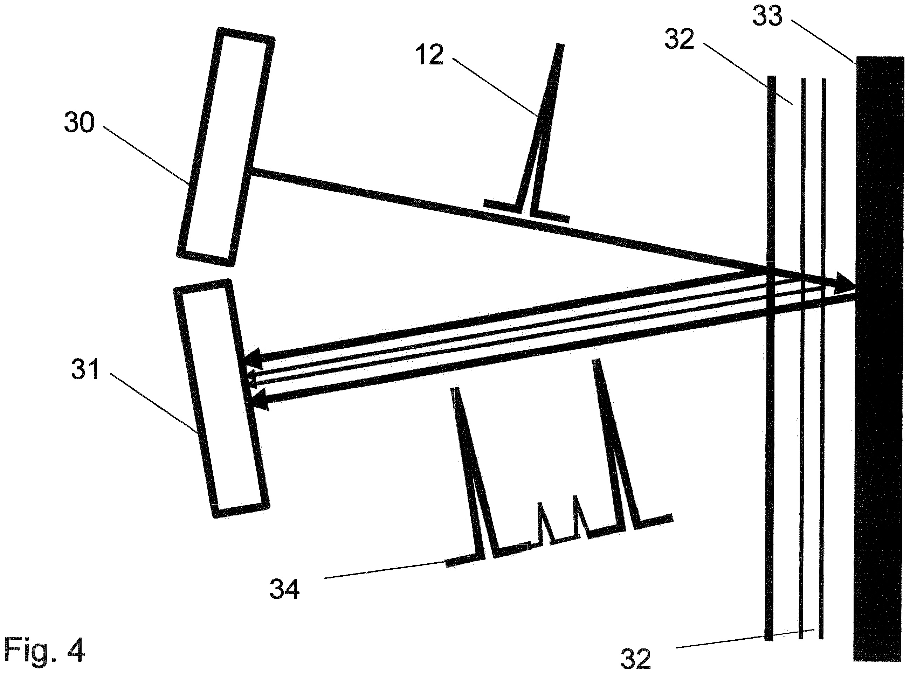

Ein anderes Beispiel ist die Messung der Dicke von Lackschichten 32 (vgl. Fig. 4), und zwar innerhalb von Multischicht-Systemen und kontaktfrei bei noch feuchten Lacken, sodass der laufende Lackierungsprozess z.B. einer Auto-Karosserie gesteuert werden kann. Für diese Messung wird ein THz-Puls 12 auf eine lackierte Metallfläche 33 gerichtet. An den verschiedenen Grenzflächen zwischen den Lackschichten 32 (typisch Rostschutz - Füllung - Farblack - Klarlack) sowie dem Metall-Träger 33 erfolgen nun Reflexionen 34, die sich in der Zeitlage unterscheiden. Die reflektierten THz-Pulse 34 werden nun zur Empfangsantenne 31 geleitet und dort wird mit dem abtastenden Laserpuls der Zeitversatz der reflektierten THz-Pulse gemessen. Bei Kenntnis der Brechungsindizes der Schichten 32 können nun die einzelnen Dicken im Schichtpaket ermittelt werden. Die Brechungsindizes von den Lacken liegen oftmals im Bereich 1,5 bis 1,6 für die THz-Strahlung.

Bedacht werden muss nun, dass die Brechungsindizes der Lacke sich nur relativ gering voneinander unterscheiden, die Reflexionsamplituden an den inneren Grenzflächen also klein sind, während die Grenzflächen Luft zu Lack oder Lack zu Metall viel stärkere Reflexionen bewirken. Dieses THz-Reflexionsmuster 34 ist schematisch in Fig. 4 skizziert.

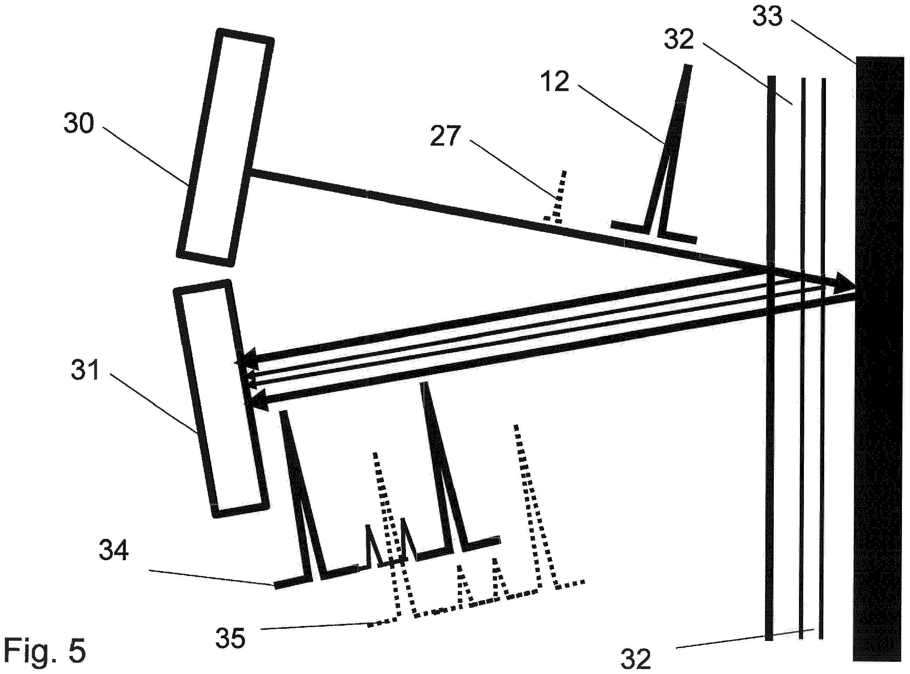

Emittiert derTHz-Sender 30 nun durch optische Mehrfach-Anregung Echo-Pulse, so entsteht eine zeitverzögertes Replika 35 des Reflexionsmusters 34 (vgl. Fig. 5). Dabei kann im Replika 35 die starke Reflektion an der Luftgrenze gerade nahe bei den schwachen Reflexionen des Hauptpulses an den internen Grenzflächen liegen, vgl. Fig. 5. Weiterhin kann durch Echo-Pulse im Empfänger 31 die starke Reflexion an der Lack-Metall Grenzfläche gerade in das Zeitfenster fallen, in dem der Hauptpuls die schwachen Reflexionen an den Übergängen zwischen den einzelnen Lackschichten abtastet.

Aus dem Obigen wird somit offensichtlich, dass die Mess-Qualität auch durch schwache Echo-Pulse erheblich beeinträchtigt werden kann. Echos in den THz Antennen - sowohl in Sender 30 als auch in Empfänger 31 - sollten also unbedingt vermieden werden.

Das vorstehend gezeigte Beispiel soll die Wichtigkeit der Echo-Unterdrückung verdeutlichen. Aber auch in Mess-Systemen in Transmissions-Anordnung oder bei spektroskopischen Analysen, bei denen eine Fourier-Transformation des detektierten Pulszuges zum Einsatz kommt, können die Echo-Pulse erheblich stören und deren störende Wirkung kann nicht immer heraus gerechnet werden. In sogenannten "continuous wave" THz-Systemen (CW THz-Systemen) sind Echo-Signale nicht so augenfällig, aber nachvollziehbar deformieren sie auch hier die optischen Schwebungssignale und die Phase und Form der THz-Wellen.

Es ist Aufgabe der Erfindung, eine Anordnung zu konzipieren, mit der die oben geschilderten Probleme zumindest teilweise gelöst werden können. Es wäre insbesondere vorteilhaft, eine Anordnung bereitzustellen, mit der die genannten Echo-Pulse verhindert oder zumindest reduziert werden können. Außerdem wäre es vorteilhaft, wenn ein Verfahren zur Herstellung der Anordnung bereitgestellt werden kann.

Diese Aufgabe wird erfindungsgemäß durch eine Anordnung, eine Antenne, ein Terahertzsystem und ein Verfahren gemäß den unabhängigen Ansprüchen gelöst. Weiterbildungen sind Gegenstände der abhängigen Ansprüche sowie der nachstehenden Beschreibung.

Gemäß einem Aspekt der vorliegenden Erfindung wird eine Anordnung für eine Antenne zum Erzeugen oder Empfangen von Terahertz-Strahlung bereitgestellt. Die Anordnung umfasst:
- eine photoaktive Schicht, welche durch optische Strahlung im Bereich 1200 nm bis 1700 nm aktivierbar ist,
- ein für die optische Strahlung transparentes Substrat, auf dem die photoaktive Schicht befestigt ist,
- einen für die optische Strahlung transparenten Träger, wobei das Substrat auf dem Träger befestigt ist und zwischen der photoaktiven Schicht und dem Träger angeordnet ist.

Das Substrat und der Träger sind aus einem gleichen Material hergestellt. Weiter weist die Anordnung eine erste haftvermittelnde Schicht auf, wobei die erste haftvermittelnde Schicht zwischen der photoaktiven Schicht und dem Substrat angeordnet ist und beide flächig miteinander verbindet. Die erste haftvermittelnde Schicht weist eine Schichtdicke von höchstens 5 µm auf.

Durch die geringe Dicke der ersten haftvermittelnden Schicht ist die Laufzeit des Lichtes zur Substrat-Grenzfläche und zurück relativ kurz. Somit regen durch die erste haftvermittelnde Schicht verursachte optische Reflexionen fast zeitgleich mit dem Anregungslicht die photoaktive Schicht an. Somit können räumlich getrennte Echo-Pulse vermieden werden.

Dadurch dass das Substrat und der Träger aus dem gleichen Material hergestellt sind, weisen sie einen gleichen Brechungsindex auf. Folglich gibt es beim Übergang der Materialien keinen Sprung des Brechungsindex. Hierdurch können Reflektionen an den Grenzflächen der Materialien und somit die obengenannten optischen Reflexionen bzw. die optischen Echo-Pulse erheblich reduziert werden.

Die erste haftvermittelnde Schicht ermöglicht einen flächenhaft bündigen Kontakt zwischen der photoaktiven Schicht und dem Substrat. Hierdurch können insbesondere Luftspalte zwischen der photoaktiven Schicht und dem Substrat unterbunden bzw. reduziert werden. Durch die geringe Schichtdicke der haftvermittelnden Schicht können Grenzflächen nahe an die photoaktive Schicht gebracht werden, sodass an der Grenzfläche Substrat zu haftvermittelnder Schicht reflektierte Pulse innerhalb der Pulsbreite der optischen Original-Pulse liegen. Die reflektierten optischen Pulse können hierdurch mit dem Originalpuls verschmelzen, wodurch die Bildung getrennter Echo-Pulse vermieden werden kann.

Materialien oder Komponenten sollen im Sinne der vorliegenden Schrift als transparent bezeichnet werden, wenn sie durchlässig für mindestens 90 % und/oder mindestens 95 % und/oder 99 % der einfallenden Strahlung im interessierenden elektromagnetischen Spektralbereich sind.

Die photoaktive Schicht kann eine Schichtdicke haben, die kleiner als eine Substratdicke des Substrats ist. Beispielsweise hat die photoaktive Schicht eine Schichtdicke von höchstens 10 µm, vorzugsweise höchstens 5 µm. Insbesondere kann die Schichtdicke im Bereich 1 µm bis 2 µm liegen. Derartige Schichtdicken sind allerdings oftmals nicht hinreichend mechanisch stabil. Das Substrat dient somit hauptsächlich der mechanischen Stabilisierung der photoaktiven Schicht.

Das Substrat kann eine Dicke haben, die mindestens 10-mal oder mindestens 100-mal größer als die Schichtdicke der photoaktiven Schicht ist. Es kann vorgesehen sein, dass das Substrat eine Substratdicke von höchstens 1 mm, vorzugsweise höchstens 0,5 mm und/oder wenigstens 0,2 mm, insbesondere wenigstens als 0,3 mm aufweist. Derartige Substratdicken sind typisch für Halbleiterscheiben bzw. Wafer. Das Substrat kann somit aus einer Halbleiterscheibe, vorzugsweise einem Wafer oder einem Halbleiter-Chip gefertigt sein. Die auf dem Wafer befestigte photoaktive Schicht kann dann einer typischen Wafer-Prozessierung unterworfen werden und es können so eine Vielzahl von Strukturen parallel bearbeitet werden. Eine der photoaktiven Schicht abgewandte Seite des Substrats grenzt vorzugsweise direkt an den Träger an. Hierdurch können störende Reflektionen ebenfalls verringert werden.

Gemäß einer Variante weist der Träger eine Trägerdicke von mindestens 3 mm, vorzugsweise mindestens 5 mm, insbesondere mindestens 7 mm auf. Die Substratdicke ist somit üblicherweise kleiner als die Trägerdicke. Die Trägerdicke kann z.B. mindestens fünfmal so groß sein wie die Substratdicke. Aufgrund der relativ großen Trägerdicke im Vergleich zur Schichtdicke und der Substratdicke können die optischen Laufzeiten der optischen Strahlung im Träger relativ lang sein, wodurch die optischen Reflektionen zeitlich verschoben werden können. So können unvermeidliche reflektierende Grenzflächen mit Abstand zur photoaktiven Schicht durch Erhöhung der Dicke des angrenzenden Trägers außerhalb eines interessierenden Messfensters einer Messung verschoben werden, sodass die Messung nicht mehr beeinträchtigt wird.

Dicken oder Schichtdicken werden in der vorliegenden Schrift vorzugsweise senkrecht zu Schichtebenen und/oder senkrecht zu planen Oberflächen gemessen. Typischerweise werden sämtliche Dicken und Schichtdicken entlang einer gleichen Richtung gemessen.

Es kann vorgesehen sein, dass eine dem Substrat abgewandte Seite der photoaktiven Schicht zumindest bereichsweise beschichtungsfrei ist und insbesondere an der Umgebungsluft freiliegt. Herstellungsbedingt (s. unten) kann es vorkommen, dass die dem Substrat abgewandte Seite der photoaktiven Schicht bereichsweise InP-Rückstände aufweist.

Die optische Strahlung im Sinne der vorliegenden Schrift wird als die elektromagnetische Strahlung verstanden, welche zum Anregen der photoaktiven Schicht benötigt wird, sodass in der photoaktiven Schicht Elektron-Loch-Paare erzeugt werden. Die Anregungsenergie der optischen Strahlung hängt hierbei von einer Bandlücke, also einem Abstand zwischen einem Valenzband und einem Leitungsband, des verwendeten photoaktiven Materials ab. Umgekehrt kann das photoaktive Material der photoaktiven Schicht derart gewählt werden, dass die Bandlücke auf eine bestimmte Anregungsenergie abgestimmt ist. Sofern die Bandlücke temperaturabhängig ist, seien hier stets ihre in üblicher Weise definierten Werte bei Betriebstemperatur gemeint, typischerweise bei zwischen 10 °C und 50 °C, vorzugsweise zwischen 15 °C und 25 °C. Um auf bekannte Komponenten der optischen Telekommunikationstechnik zurückgreifen zu können, wird die photoaktive Schicht eine Bandlücke aufweisen, welche einer Anregungswellenlänge von mindestens 1200 nm, vorzugsweise mindestens 1250 und/oder höchstens 1700 nm, vorzugsweise höchstens 1650 nm entspricht. Die photoaktive Schicht kann zum Beispiel zumindest überwiegend aus einem Halbleitermaterial, wie InGaAs, InAlAs, InGaAsP, InGaAlAs, InGaAlAsP und/oder GaAlAs hergestellt sein, oder eine Kombination von mehreren Halbleitern umfassen. Der verwendete Halbleiter ist üblicherweise mit einem Übergangsmetall, insbesondere Fe, Rh oder Ru, dotiert. Eine Konzentration des Übergangsmetalls in der photoaktiven Schicht kann mindestens 10¹⁸ cm⁻³, vorzugsweise mindestens 10¹⁹ cm⁻³ betragen.

Vorzugsweise ist die photoaktive Schicht aus einer einzigen Schicht des photoaktiven Materials gebildet.

Alternativ kann die photoaktive Schicht mehrere Teilschichten umfassen. Beispielsweise können mindestens eine aktive Schicht und eine angrenzende Schicht vorgesehen sein. In der Regel wird dabei die aktive Schicht oder jede der aktiven Schichten jeweils zwischen zwei angrenzenden Schichten eingebettet sein. Die angrenzenden Schichten dienen dabei als Rekombinationsschichten. Es kann vorgesehen sein, dass die photoaktive Schicht eine periodische Schichtstruktur hat mit einer Vielzahl von abwechselnd angeordneten aktiven Schichten und Rekombinationsschichte n; wobei z. B. 100 oder mehr aktive Schichten vorgesehen sein können.

Die Wirkung verbleibender Echo-Pulse kann weiter minimiert bzw. reduziert werden, indem die Ausdehnung der photoaktiven Schicht auf die unbedingt nötige Fläche beschränkt wird. Die photoaktive Schicht kann eine Grundfläche von höchstens 1 mm², vorzugsweise höchstens 0,1 mm², bevorzugt höchstens 0,01 mm² aufweisen. Eine senkrechte Projektion der photoaktiven Schicht auf das Substrat kann eine Fläche von höchstens 1 mm², vorzugsweise höchstens 0,1 mm², bevorzugt höchstens 0,01 mm² aufweisen. Die genannte Projektion senkrecht auf das Substrat ist hierbei eine Parallelprojektion, d.h. die von der photoaktiven Schicht ausgehenden Projektionsstrahlen, die als Projektionslinien bezeichnet werden, sind parallel zueinander. Die photoaktive Schicht kann eine seitliche Ausdehnung gemessen parallel zum Substrat und/oder einen Durchmesser von höchstens 1 mm, bevorzugt höchstens 0,1 mm aufweisen. Die photoaktive Schicht kann insbesondere als Mesa-Struktur vorliegen.

Das Substrat kann zum Beispiel als planparallele Platte ausgeführt sein. Der Träger kann als planparalleler Körper oder als keilförmiger Körper ausgeführt sein. Das Substrat kann direkt an den Träger angrenzen, d.h. ohne eine dazwischenliegende Klebeverbindung oder Schicht. In alternativen Ausführungsformen ist eine zweite haftvermittelnde Schicht vorgesehen, welche zwischen dem Substrat und dem Träger angeordnet ist und beide flächig miteinander verbindet.

Die erste haftvermittelnde Schicht und die zweite haftvermittelnde Schicht können aus dem gleichen Material bestehen oder unterschiedliche Materialien umfassen. Es kommen unterschiedliche Materialien für die jeweiligen haftvermittelnde Schichten in Betracht. Hierbei sollte das Material einerseits die zu verbindenden Komponenten flächig und bündig miteinander verbinden. Andererseits sollte das Material transparent für die THz-Strahlung und/oder die optische Strahlung sein. In einer Ausführungsform ist die erste haftvermittelnde Schicht und/oder die zweite haftvermittelnde Schicht eine Klebeschicht, zum Beispiel eine Schicht aus Benzocyclobuten (BCB). Andere geeignete Materialien sind auch denkbar.

In einer Ausführungsform ist das Substrat als Silizium-Wafer ausgeführt. Der Träger kann als Silizium-Körper ausgeführt sein. Silizium-Wafer und Silizium-Körper sind mit hoher Oberflächenplanarität verfügbar. Außerdem sind dünne Si-Wafer (0,2 mm - 1 mm) in der Regel elastisch und biegbar, und passen sich gut an den angrenzenden Silizium-Körper, also an den Träger, an. In manchen Ausführungsformen können durch van der Waals Kräfte / Kohäsion flächenhaft lückenlose Si-Si Verbindungen zwischen dem als Si-Wafer ausgeführten Substrat und dem als Si-Körper ausgeführten Träger geschaffen werden. Hierdurch können vorteilhaft Luftspalte zwischen dem Träger und dem Substrat, und somit Brechungsindexsprünge, vermieden werden.

Die Anordnung kann außerdem eine Linse für die Terahertzstrahlung aufweisen. Typischerweise werden konvexe Linsen, vorzugsweise plankonvexe Linsen verwendet. Oftmals wird hierbei auf eine hemisphärische Linse oder eine hyperhemisphärische Linse zurückgegriffen. Gemäß einer Ausführungsform ist die Linse auf dem Träger befestigt. Die Linse kann an den Träger angrenzen. Es kann aber auch eine dritte haftvermittelnde Schicht zwischen dem Träger und der Linse vorgesehen sein, welche beide flächig miteinander verbindet. Alternativ kann die Linse den Träger bilden. In diesem Fall ist das Substrat also direkt auf der Linse befestigt, ohne dass ein zusätzlicher Träger vorhanden ist. Gemäß einer Variante ist die Linse aus dem gleichen Material wie das Substrat und/oder der Träger hergestellt. Die Linse kann alternativ auch aus einem Polymermaterial, wie Polymethylpenten (auch TPX oder PMP genannt), hergestellt sein. Eine Linsendicke, in der Regel gemessen an einer dicksten Stelle der Linse, kann wenigstens 2 mm, vorzugsweise wenigstens 3 mm betragen. Die Linsendicke und die Trägerdicke können gleich groß sein.

Das Substrat und/oder der Träger und/oder die Linse sind in der Regel aus einem elektrisch isolierenden Material hergestellt. Das Substrat und/oder der Träger und/oder die Linse sind üblicherweise transparent für die erzeugte Terahertzstrahlung. Weiterhin ist die Linse in der Regel ebenfalls transparent für die optische Strahlung.

Gemäß einem weiteren Aspekt der vorliegenden Erfindung wird eine Antenne zum Erzeugen oder Empfangen von Terahertz-Strahlung bereitgestellt. Die Antenne umfasst die Anordnung der zuvor beschriebenen Art. Des Weiteren weist die Antenne einen Antennenleiter mit einer ersten Teilstruktur und einer zweiten Teilstruktur auf. Die erste Teilstruktur und die zweite Teilstruktur sind durch eine Lücke voneinander beabstandet und kontaktieren die photoaktive Schicht. Hierbei können die Teilstrukturen die photoaktive Schicht sowohl elektrisch als auch mechanisch kontaktieren. Der Antennenleiter ist gewöhnlich aus einem Metall gefertigt und kann in diesem Fall zwei Metallstrukturen aufweisen. Insbesondere kann der Antennenleiter durch aufgedampftes oder gesputtertes Metall gebildet sein. Durch die Geometrie der Teilstrukturen werden z.B. Dipol, Bow-Tie oder sog. Strip-Line Antennen ausgebildet.

Typischerweise wird zumindest die Empfängerantenne des THz-Systems auf einem Photoleiter basieren. Das gleiche kann auch bei der Sendeantenne der Fall sein. Die Sendeantenne kann auch auf einer Photodiode anstelle eines Photoleiters basieren, vgl. die Veröffentlichung DE 10 2010 049 658 A1. Durch die Verwendung einer Photodiode lässt sich eine besonders hohe Effizienz der Sendeantenne erreichen.

Die photoaktive Schicht kann an einer Oberfläche oder an seitlichen Stirnflächen mit dem Antennenleiter kontaktiert sein. Beispielsweise ist der Antennenleiter auf einer dem Substrat abgewandten oder zugewandten Seite der photoaktiven Schicht angeordnet. Alternativ können die erste Teilstruktur und die zweite Teilstruktur neben der photoaktiven Schicht auf dem Substrat angeordnet sein. In diesem Fall kann die photoaktive Schicht zwischen den beiden Strukturen angeordnet sein.

Gemäß einem weiteren Aspekt wird ein Terahertzsystem zum Erzeugen und kohärenten Detektieren von Terahertzstrahlung vorgeschlagen. Das Terahertzsystem umfasst eine Laserlichtquelle und zwei jeweils optisch mit der Laserlichtquelle gekoppelte und durch optische Strahlung dieser Laserlichtquelle aktivierbare THz-Antennen, von denen eine erste als Sendeantenne und eine zweite als Empfängerantenne dient. Die Sendeantenne und/oder die Empfängerantenne umfassen jeweils eine Antenne der zuvor beschriebenen Art.

Das Licht der Laserlichtquelle hat vorzugsweise eine Wellenlänge von wenigstens 1200 nm, insbesondere wenigstens 1250 nm und/oder höchstens 1700 nm, insbesondere höchstens 1680 nm. Gemäß manchen Ausführungsformen wird ein Pulslaser als Laserlichtquelle verwendet. Alternativ kann auch ein Dauerstrichlaser (CW-Laser) verwendet werden.

Die Wellenlänge der Laserlichtquelle des Terahertzsystems kann in einem der Bänder der Telekommunikation liegen, zum Beispiel im O-Band, E-Band, S-Band, C-Band, L-Band und/oder U-Band im Wellenlängenbereich zwischen 1260 nm und 1675 nm, insbesondere bei 1300 nm und 1550 nm. Die Verwendung eines Pulslasers als Laserlichtquelle zum Aktivieren der THz-Antennen ist insbesondere dann von Vorteil, wenn beide THz-Antennen photoleiterbasiert sind, da sich mit einem Pulslaser besonders gut eine hohe Sendeleistung und eine hohe Empfängerempfindlichkeit verwirklichen lassen. Für eine Ausführung des Terahertzsystems als Puls-System kann ein Femtosekunden-Pulslaser mit einer Wellenlänge zwischen 1200 nm und 1700 nm verwendet werden. Femtosekundenpulse haben hierbei eine Dauer von weniger als eine Pikosekunde, z.B. zwischen 10 fs und 990 fs.

Bei anderen Ausführungen kann die Laserlichtquelle als eine optische Schwebungsquelle ausgebildet sein. Beispielsweise kann die Laserlichtquelle durch einen Zweimodenlaser oder ein System zweier Laser gegeben sein und eingerichtet sein zur Erzeugung eines Schwebungssignals zweier Laserwellen, wobei eine Schwebungsfrequenz dieses Schwebungssignals mindestens 0,05 THz betragen sollte und typischerweise zwischen 0,05 THz und 20 THz, vorzugsweise zwischen 0,1 THz und 10 THz liegt, damit die Terahertzstrahlung mit entsprechender Frequenz und Wellenlänge erzeugt werden kann. Die Ausführung mit einem Zweimodenlaser oder einem System zweier Laser und die Aktivierung der THz-Antennen mit einem entsprechenden Schwebungssignal führt insbesondere dann zu befriedigenden Ergebnissen, wenn die Sendeantenne photodiodenbasiert ist, da sich durch die Verwendung einer photodiodenbasierten Sendeantenne das bei einer Aktivierung durch ein Schwebungssignal besonders gravierende Problem zu geringer Sendeleistungen vermeiden lässt.

Vorzugsweise ist eine Linsenanordnung zum Fokussieren des Laserlichts auf die photoaktive Schicht vorgesehen. Da in der Regel das Laserlicht bzw. die optische Strahlung nicht vollständig durch die photoaktive Schicht absorbiert wird, durchquert ein verbleibender Teil des Lichts die photoaktive Schicht und nachgeschaltete Schichten (Substrat, haftvermittelnde Schicht, Träger und/oder THz-Linse). Ein in einem gewissen Abstand reflektierter optischer Echopuls trifft typischerweise divergent auf die photoaktive Schicht und kann dort erneut großflächig Photoladungsträger erzeugen. Auch bei einem gewissen Abstand zu den Teilstrukturen des Antennenleiters können diese Photoladungsträger den Antennenleiter noch aktivieren, wodurch THz-Echopulse erzeugt werden. Aus diesem Grund ist es vorteilhaft, wenn eine seitliche Ausdehnung der photoaktiven Schicht derart begrenzt wird, dass der divergent reflektierte Echopuls die photoaktive Schicht nicht mehr treffen kann. Um dies zu realisieren kann die photoaktive Schicht z.B. als Mesastruktur ausgebildet sein. Die Teilstrukturen können dann als Seitenkontakten ausgebildet sein. In diesem Fall findet außerhalb des Mesas der Photoeffekt nicht statt, und so bleibt ein großer Teil der optischen Echo-Pulse bezüglich einer Anregung der photoaktiven Schicht wirkungslos. Für eine bevorzugte maximale seitliche Ausdehnung bzw. flächige Ausdehnung der photoaktiven Schicht sei auf die oben genannten Abmessungen verwiesen.

Gemäß einem weiteren Aspekt wird ein Verfahren zum Herstellen einer Anordnung für eine Antenne zum Erzeugen oder Empfangen von Terahertz-Strahlung bereitgestellt. Das Verfahren umfasst wenigstens die Schritte:
- Herstellen einer photoaktiven Schicht auf einem Hilfssubstrat, welches zumindest überwiegend aus InP gebildet ist,
- flächiges Verbinden der photoaktiven Schicht mit einem Substrat mittels einer ersten haftvermittelnden Schicht, welche eine Schichtdicke von höchstens 5 µm aufweist,
- Entfernen des Hilfssubstrats, vorzugsweise durch chemisches Ätzen, und
- Befestigen des Substrats auf einem Träger, sodass das Substrat zwischen der photoaktiven Schicht und dem Träger angeordnet ist.

Die photoaktive Schicht ist durch optische Strahlung im Bereich 1200 nm bis 1700 nm aktivierbar. Außerdem sind das Substrat und der Träger aus einem gleichen Material hergestellt. Das Substrat und der Träger sind zudem transparent für die optische Strahlung.

Die photoaktive Schicht kann insbesondere epitaktisch gitterangepasst auf dem Hilfssubstrat aus InP aufgewachsen werden. Geeignete Materialien für die photoaktive Schicht mit der geforderten Bandlücke können InGaAs, InAIAs, InGaAsP, InGaAlAs, InGaAlAsP und/oder GaAlAs umfassen. Für weitere Eigenschaften der photoaktiven Schicht sei auf die obigen Ausführungen verwiesen.

Nachteile eines auf InP basiertem Substrats sind oben beschrieben (z.B. Brechungsindexsprung von InP zu Si; InP ist oftmals spröde, wodurch Luftspalte an den Grenzflächen der Komponenten entstehen). Deswegen wird das InP Material erfindungsgemäß lediglich als Hilfssubstrat zum Aufwachsen der photoaktiven Schicht verwendet. Nach dem Herstellen der photoaktiven Schicht wird das Hilfssubstrat aus InP entfernt. Das Hilfssubstrat wird vorzugsweise durch chemisches Ätzen entfernt. Alternativ kann das Hilfssubstrat durch mechanisches Ätzen entfernt werden. Vorzugsweise wird das Hilfssubstrat vollständig entfernt. Obwohl eine vollständige Entfernung des Hilfssubstrats angestrebt wird, kann es vorkommen, dass in der mit dem beschriebenen Verfahren hergestellten Anordnung die photoaktive Schicht auf einer dem Substrat abgewandten Seite nachweisbare Materialrückstände des Hilfssubstrats aufweist. Die auf dem InP-Hilfssubstrat erzeugte photoaktive Schicht alleine ist in der Regel nicht hinreichend mechanisch stabil, da die photoaktive Schicht oftmals eine Schichtdicke von höchstens einigen Mikrometern aufweist. Aus diesem Grund wird die photoaktive Schicht vor dem Entfernen des InP-Hilfssubstrats mit dem Substrat verbunden, welches somit zur Stabilisierung der photoaktiven Schicht vorgesehen ist. Vor dem Entfernen des Hilfssubstrats befinden sich das Substrat und das Hilfssubstrat üblicherweise an gegenüberliegenden Seiten der photoaktiven Schicht.

Gemäß einer Variante wird die photoaktive Schicht mittels Molekularstrahlepitaxie bei einer Temperatur 200 °C bis 450 °C, vorzugsweise 400 °C aufgewachsen. Gemäß einer weiteren Variante wird die photoaktive Schicht epitaktisch aufgewachsen und mit einem Übergangsmetall wie Fe, Rh, oder Ru dotiert, vorzugsweise in Konzentrationen oberhalb 10¹⁸ cm⁻³.

Das Verfahren kann durch den folgenden Prozessschritt ergänzt werden:
- Aufbringen eines Antennenleiters mit einer ersten Teilstruktur und einer zweiten Teilstruktur auf die photoaktive Schicht derart, dass die beiden Teilstrukturen voneinander beabstandet sind und die photoaktive Schicht kontaktieren.

Hierbei kann der Schritt des Aufbringens des Antennenleiters auf die photoaktive Schicht vor dem Verbinden der photoaktiven Schicht mit dem Substrat oder nach dem Entfernen des Hilfssubstrats erfolgen.

Optional kann, z.B. zur Bildung einer Mesa-Struktur, eine seitliche Ausdehnung der photoaktiven Schicht reduziert werden. Dies kann z.B. nasschemisch und/oder durch Trockenätzprozesse erfolgen. In einer Variante des Verfahrens kann eine Oberflächenpassivierung auf die photoaktive Schicht vorgesehen werden. Die Oberflächenpassivierung kann zum Beispiel Siliziumnitrid und/oder Siliziumoxid umfassen.

Das Substrat kann vor dem Befestigen mit dem Träger noch als unverarbeiteter Wafer vorliegen, auf dem mindestens eine Struktur angeordnet ist. So kann mindestens eine Struktur (Teilanordnung), umfassend die photoaktive Schicht, die erste haftvermittelnde Schicht und/oder den Antennenleiter, auf dem Substrat befestigt sein. In der Regel ist eine Vielzahl von separaten Strukturen, z.B. mindestens 5, mindestens 10, mindestens 50 oder sogar mindestens 100 Strukturen, auf dem Substrat angeordnet. Hierdurch kann eine Prozessierung der aktiven Schicht auf dem Substrat mit etablierten Technologien der Halbleiterfertigung zur parallelen Ausgestaltung einer Vielzahl verschiedener Strukturen erfolgen. Anschließend können die verschiedenen, prozessierten Strukturen vereinzelt bzw. voneinander getrennt werden. Insbesondere kann der Substrat-Wafer hierbei in einzelne Chips geteilt werden. Das Verfahren kann somit durch Vereinzelung der auf dem Substrat prozessierten Strukturen und Befestigung des Substrats mit der prozessierten Struktur auf dem Träger zur Bildung der oben genannten Anordnung abgeschlossen werden.

Das Verfahren eignet sich insbesondere zur Herstellung der oben genannten Anordnung und der genannten Antenne. Merkmale die in Bezug auf die Anordnung und die Antenne genannt werden können auch für das Verfahren beansprucht werden und andersherum.

Ausführungsbeispiele der Anordnung, der Antenne und des Terahertzsystems sind in den beigefügten Figuren dargestellt und werden anhand der nachfolgenden Beschreibung näher erläutert.

Es zeigen
- Fig. 1: eine schematische Darstellung einer photoleitenden THz-Antenne gemäß dem Stand der Technik;
- Fig. 2: die photoleitende THz-Antenne aus Fig. 1 mit optischen Reflexionen;
- Fig. 3: normierte Terahertz-Amplituden von verschiedenen THz-Sendern aufgetragen über eine Verzögerungszeit und gemessen in einer THz-Empfängerantenne gemäß dem Stand der Technik;
- Fig. 4: schematisch einen Aufbau zum Messen von Dicken von Lackschichten;
- Fig. 5: den Aufbau der Fig. 4 mit THz-Echo-Pulsen;

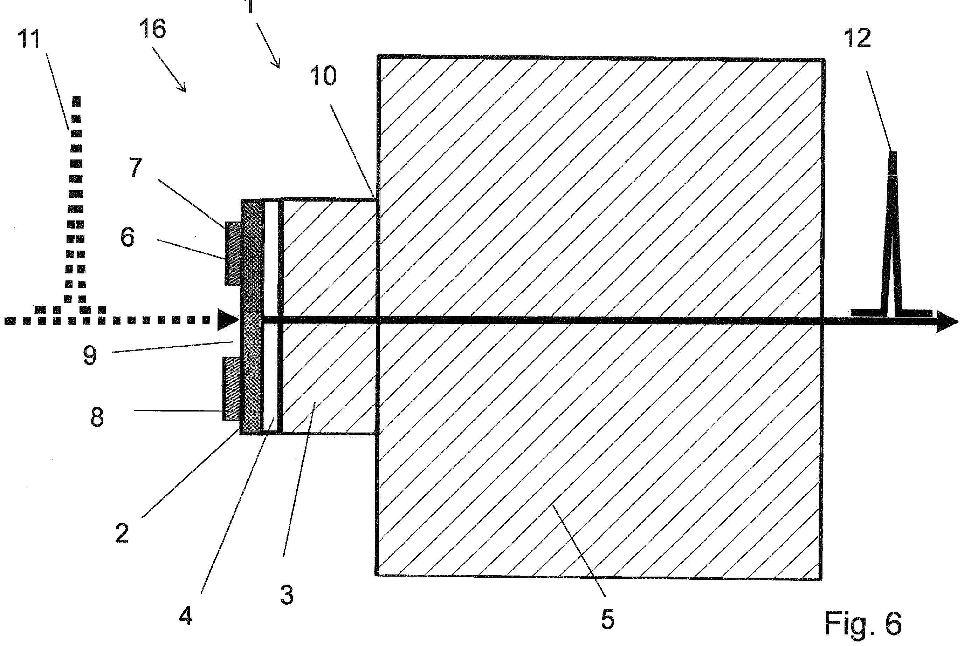

- Fig. 6: eine schematische Darstellung einer THz-Antenne gemäß einer Ausführungsform der vorliegenden Erfindung;

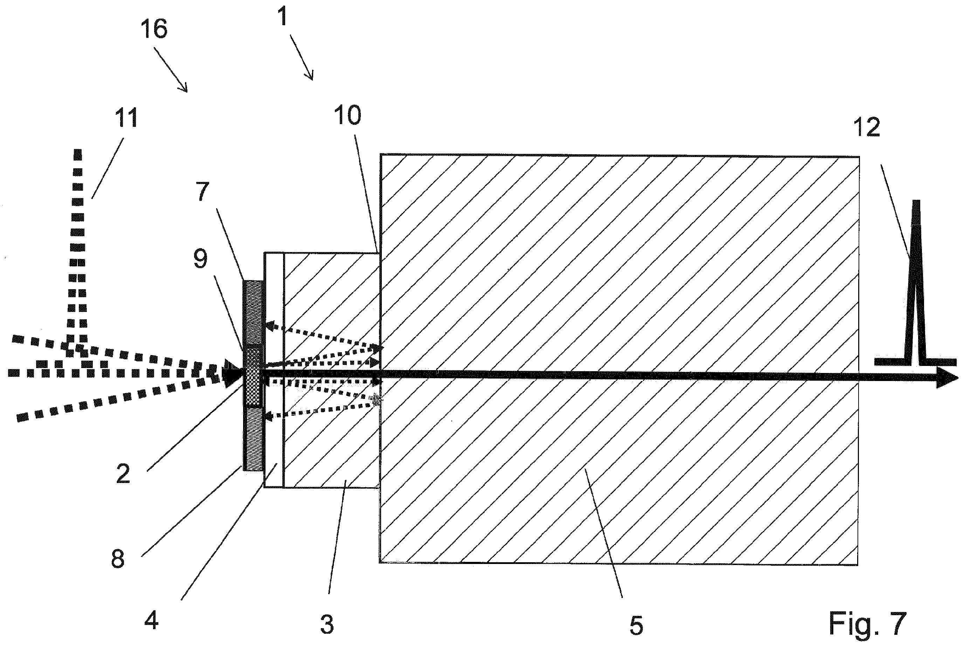

- Fig. 7: eine schematische Darstellung einer weiteren THz- Antenne gemäß einer Ausführungsform der vorliegenden Erfindung;

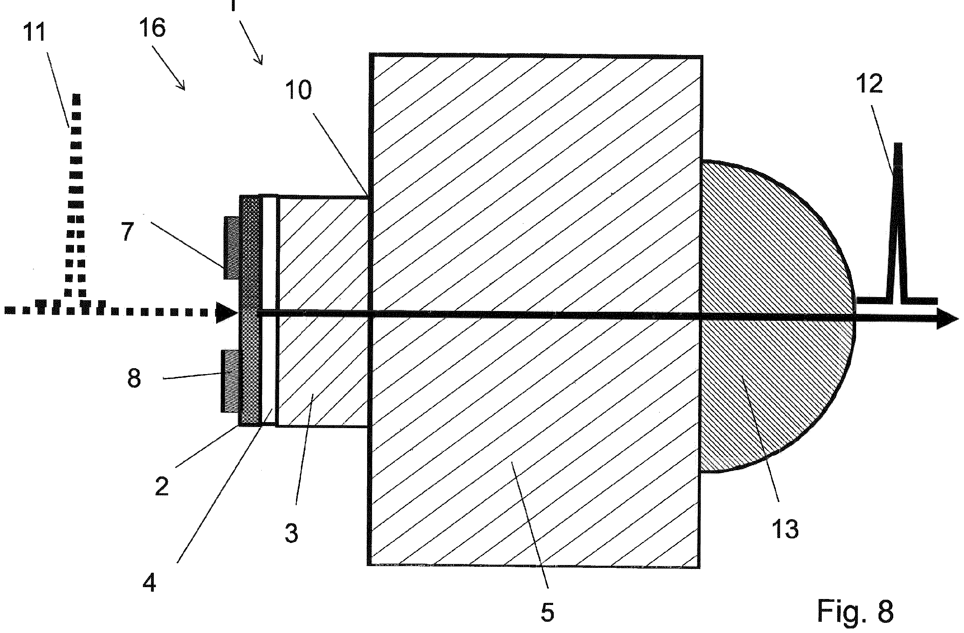

- Fig. 8: eine schematische Darstellung einer weiteren THz- Antenne gemäß einer Ausführungsform der vorliegenden Erfindung;

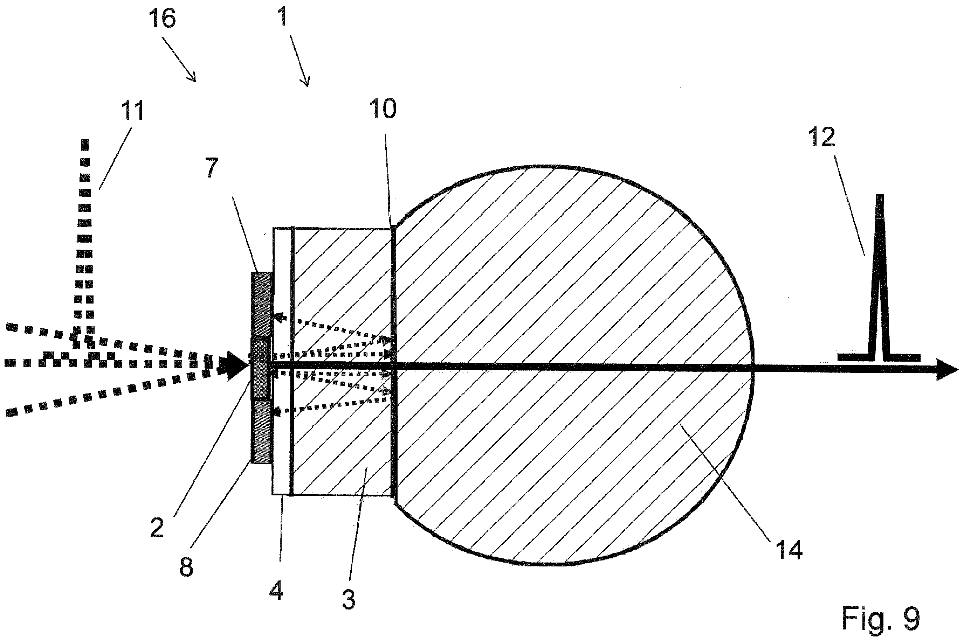

- Fig. 9: eine schematische Darstellung einer weiteren THz-Antenne gemäß einer Ausführungsform der vorliegenden Erfindung;

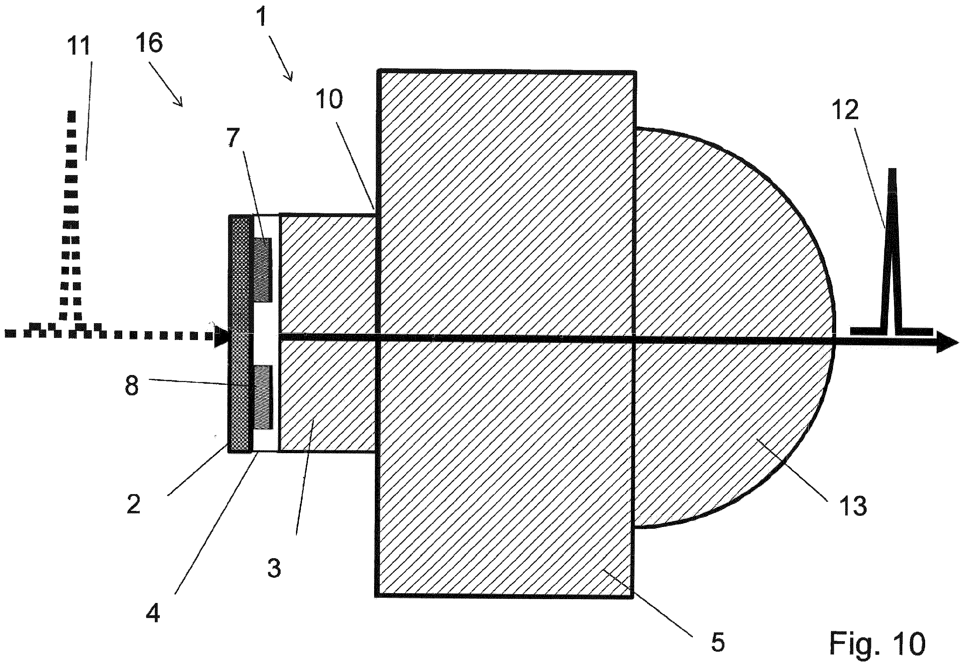

- Fig. 10: eine schematische Darstellung einer weiteren THz- Antenne gemäß einer Ausführungsform der vorliegenden Erfindung; und

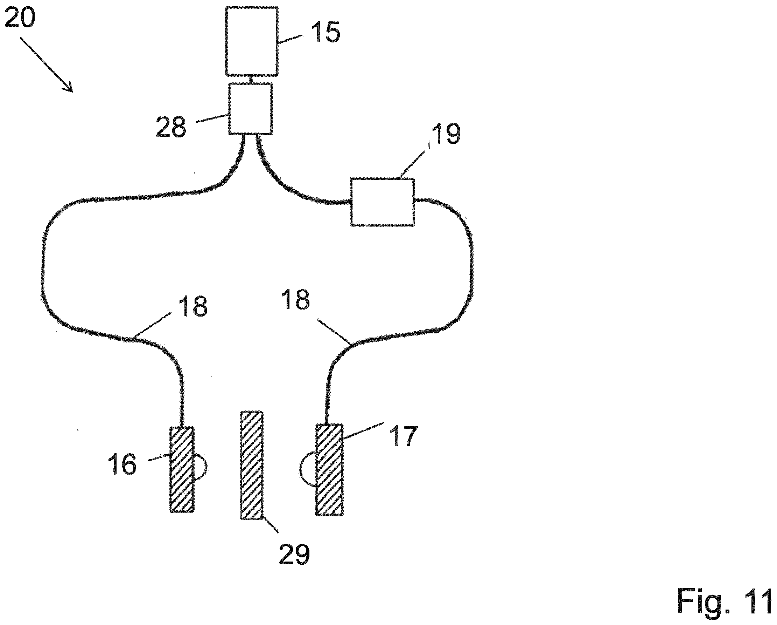

- Fig. 11: eine schematische Darstellung eines Terahertzsystems zum Erzeugen und kohärenten Detektieren von Terahertzstrahlung gemäß einer Ausführungsform der vorliegenden Erfindung.

Das in Fig. 11 gezeigte Terahertzsystem 20 weist eine Laserlichtquelle 15, eine Sendeantenne 16 und eine Empfängerantenne 17 auf. Bei der Sendeantenne 16 und der Empfängerantenne 17 handelt es sich jeweils um eine durch Licht der Laserlichtquelle 15 aktivierbare THz-Antenne. Dazu ist ein Strahlteiler 28 hinter einen Ausgang der Laserlichtquelle 15 geschaltet, wobei die Sendeantenne 16 und die Empfängerantenne 17 jeweils durch eine Lichtleitfaser 18 mit einem von zwei Ausgängen des Strahlteilers 28 verbunden sind.

Bei der Laserlichtquelle 15 handelt es sich um einen Pulslaser, wobei eine Wellenlänge der Laserlichtquelle 15 zwischen 1200 nm und 1700 nm liegt und vorzugsweise 1300 nm oder 1550 nm beträgt. An einem Eingang oder in einem Verlauf einer der Lichtleitfasern 18 kann eine steuerbare optische Verzögerungsschaltung 19 angeordnet sein, mit der eine relative Zeitlage optischer Steuersignale zur Aktivierung der beiden THz-Antennen 16, 17 verschoben werden kann. Dazu kann die Verzögerungsschaltung 19 z.B. eine mit einem variablen elektrischen Feld beaufschlagbare Verzögerungsleitung aufweisen. Schließlich ist auch eine zwischen der Sendeantenne 16 und der Empfängerantenne 17 angeordnete Probe 29 dargestellt, die mit dem Terahertzsystem 20 untersucht werden kann.

Der die Laserlichtquelle 15 bildende Pulslaser kann ein Faser-Pulslaser, z.B. mit Erbium-Dotierung, oder ein Halbleiter-Pulslaser, z.B. auf einem Materialsystem InGaAsP/InP basierend, sein.

Für weitere Details des Terahertzsystems 20 sei ergänzend auf die Veröffentlichung DE 10 2010 049 658 A1 verwiesen.

Im Folgenden wird auf Einzelzeiten der THz-Antennen 16 und 17 des Terahertzsystems 20 eingegangen. Die Figuren 6 bis 10 zeigen schematisch THz-Antennen gemäß Ausführungsformen der vorliegenden Erfindung. Hierbei sind der Übersichtlichkeit halber lediglich THz-Sendeantennen 16 gezeigt. Es ist jedoch klar, dass die in den Figuren 6-10 gezeigten THz-Sendeantennen auch als THz-Empfängerantennen verwendet werden können.

Die Fig. 6 zeigt schematisch eine Anordnung 1, welche ein Bestandteil der Antenne 16 zum Erzeugen von Terahertz-Strahlung 12 ist. Die Anordnung 1 umfasst eine photoaktive Schicht 2, ein Substrat 3, eine erste haftvermittelnde Schicht 4 und einen Träger 5.

Die photoaktive Schicht 2 ist durch optische Strahlung 11 des Lasers 15 im Bereich 1200 nm bis 1700 nm aktivierbar und hat somit eine entsprechende Bandlücke. Geeignete Halbleiter für die photoaktive Schicht 2 wären zum Beispiel InGaAs, InAlAs, InGaAsP, InGaAlAs, InGaAlAsP oder GaAlAs. Der für die photoaktive Schicht 2 verwendete Halbleiter ist in der Regel mit einem Übergangsmetall wie Fe, Rh oder Ru, in einer Konzentration von mindestens 10¹⁸ cm⁻³, vorzugsweise mindestens 10¹⁹ cm⁻³dotiert. Für die Erzeugung von THz-Strahlung sind Schichtdicken der photoaktiven Schicht 2 von höchstens 10 µm und mindestens 0,5 µm vorteilhaft. Im gezeigten Ausführungsbeispiel kann die Schichtdicke insgesamt 1 µm bis2 µm betragen. Vorzugsweise besteht die photoaktive Schicht 2 aus einer einzigen Schicht des photoaktiven Materials. Die photoaktive Schicht 2 kann alternativ mehrere Teilschichten umfassen. Beispielsweise können mindestens eine aktive Schicht und eine angrenzende Schicht vorgesehen sein.

Die photoaktive Schicht 2 ist auf dem Substrat 3 befestigt. Für die Befestigung wird hierbei die flächig aufgetragene erste haftvermittelnde Schicht 4 benutzt. Die erste haftvermittelnde Schicht 4 ist also zwischen der photoaktiven Schicht 2 und dem Substrat 3 angeordnet und verbindet beide flächig und bündig miteinander. Durch die haftvermittelnde Schicht 4 können Luftspalte zwischen dem Substrat 3 und der photoaktiven Schicht 2 weitgehend vermieden werden. Um nachteilige Reflexionen des Laserlichts 12 weiter zu unterdrücken, sollte eine Schichtdicke der haftvermittelnden Schicht 4 höchstens 5 µm sein. Denkbar wären Schichtdicken im Bereich 0,5 µm bis 2 µm. Ein geeignetes Material für die haftvermittelnden Schicht 4, welche manchmal auch Klebeschicht genannt wird, wäre zum Beispiel BCB (Benzocyclobuten), welches im Stand der Technik öfter für das sogenannte Wafer-Bonden verwendet wird.

Das Substrat 3 besteht aus einem für die Laserstrahlung 11 und die THz-Strahlung 12 transparenten Material, vorzugsweise Silizium. Das Substrat 3 ist außerdem elektrisch isolierend. Das Substrat 3 sorgt für eine mechanische Stabilität der photoaktiven Schicht 2, insbesondere während der Herstellung der Anordnung 1 (vgl. das untenstehende Herstellungsverfahren). Das Substrat 3 ist gewöhnlich als planparallele Platte ausgeführt. Das Substrat 3 kann in vorteilhafter Weise aus einem Chip eines handelsüblichen Silizium-Wafers hergestellt werden. Dies erlaubt die Anwendung von etablierten Technologien der Wafer-Prozessierung und die parallele Herstellung einer Vielzahl von Strukturen auf einem Substrat. Eine erste der photoaktiven Schicht 2 zugewandten Seite des Substrats 3 ist somit eine plane Fläche. Auf einer zweiten der photoaktiven Schicht 2 abgewandten Seite ist das Substrat auf dem Träger 5 befestigt. Das Substrat 3 ist somit zwischen der photoaktiven Schicht 2 und dem Träger 5 angeordnet. Eine dem Träger 5 zugewandten Seite des Substrats 3 ist vorzugsweise ebenfalls als plane Fläche ausgestaltet. Das Substrat 3 hat vorzugsweise eine Substratdicke, gemessen senkrecht zu einer Substratebene von der ersten Seite bis zur zweiten Seite des Substrats 3, welche wesentlich größer als die Schichtdicke der photoaktiven Schicht 2 ist. Das Substrat 3 kann z.B. eine Substratdicke von höchstens 1 mm aufweisen, wobei Substratdicken von mindestens 0,2 mm üblich sind. Im gezeigten Ausführungsbeispiel hat das Substrat 3 eine konstante Substratdicke im Bereich 300 µm bis 500 µm. Nach Abschluss der Wafer-Prozessierung werden die Strukturen vereinzelt und auf dem Träger befestigt.

Der Träger 5 ist aus dem gleichen Material wie das Substrat 3 hergestellt, hat allerdings eine vielfach größere Dicke. Im gezeigten Ausführungsbeispiel ist der Träger 5 als planparalleler Siliziumkörper oder Siliziumblock ausgeführt. Eine erste dem Substrat 3 zugewandte Seite des Trägers 5 ist daher eine plane Fläche. Außerdem ist eine zweite Seite des Trägers 5, welche dem Substrat 3 abgewandt ist, als plane Fläche ausgeführt. Die in der Antenne 16 erzeugte THz-Strahlung 12 verlässt den Träger 5 über die erste dem Substrat 3 abgewandte Seite des Trägers 5. Der Träger 5 hat vorzugsweise eine Trägerdicke, gemessen von der ersten Seite bis zur zweiten Seite des Trägers 5, welche wesentlich größer als die Substratdicke und die Dicke der photoaktiven Schicht 2 ist. Hierdurch können optische Reflexionen an der Grenzfläche Träger 5 zu Luft, d.h. an der zweiten Seite des Trägers 5, zeitlich so verzögert werden, dass sie außerhalb des interessierenden Messfensters liegen. Beispielhafte Trägerdicken sind mindestens 5 mm, vorzugsweise mindestens 8 mm. Dadurch dass der Träger 5 und das Substrat 3 aus dem gleichen Material gefertigt sind, werden Reflexionen der optischen Strahlung 11 an der Grenzfläche Substrat 3 zu Träger 5 stark unterdrückt.

Der Träger 5 und das Substrat 3 sind bündig verbunden und deren Seiten liegen flächig aneinander an, beispielsweise über einen Presskontakt. Der Träger 5 kann somit direkt an das Substrat 3 angrenzen. Alternativ kann auch eine zweite haftvermittelnde Schicht (nicht gezeigt) zwischen dem Substrat 3 und dem Träger 5 vorgesehen sein, welche das Substrat 3 und den Träger 5 flächig und bündig miteinander verbindet. Die zweite haftvermittelnde Schicht kann aus einem Polymermaterial, wie BCB, bestehen.

Außerdem ist ein Antennenleiter 6 vorgesehen, welche eine erste Teilstruktur 7 und eine zweite Teilstruktur 8 umfasst. Die erste Teilstruktur 7 und die zweite Teilstruktur 8 sind durch eine Lücke 9 voneinander beabstandet. De photoaktive Schicht 2 ist im Bereich der genannten Lücke 9 beschichtungsfrei und liegt dort an der Umgebungsluft frei. Durch die Lücke 9 tritt die optische Strahlung 11 des Lasers 15 auf die photoaktive Schicht 2. Beide Teilstrukturen 7, 8 kontaktieren die photoaktive Schicht 2 sowohl elektrisch als auch mechanisch. Die Teilstrukturen 7, 8 sind in der Regel als Metallstrukturen ausgebildet, wobei sie durch Aufdampfen oder Sputtern von Metall auf die photoaktive Schicht 2 gebildet sind. In der Ausführungsform der Fig. 6 sind die Teilstrukturen 7, 8 auf einer dem Substrat 3 abgewandten Seite der photoaktiven Schicht 2 angeordnet.

Die in der Fig. 7 gezeigte THz-Antenne 16 unterscheidet sich von der in der Fig. 6 gezeigten THz-Antenne dadurch, dass die Teilstrukturen 7, 8 des Antennenleiters 6 seitlich neben der photoaktiven Schicht 2 angeordnet sind. Die photoaktive Schicht 2 befindet sich also mittig zwischen den Teilstrukturen 7, 8. Die photoaktive Schicht 2 befindet sich innerhalb der Lücke 9 und füllt diese vollständig aus. Insbesondere ist die photoaktive Schicht 2 in der Ausführungsform der Fig. 7 als Mesa-Struktur mit Abmessungen gemessen senkrecht zur Schichtdicke von höchstens 100 µm mal 100 µm ausgeführt. Die Mesa-Struktur hat somit eine Grundfläche von höchstens 0,01 mm². Wie in der Fig. 7 angedeutet ist, hat eine senkrechte Projektion der photoaktiven Schicht 2 auf das Substrat eine Fläche, welche derart reduziert ist, dass nur noch ein sehr kleiner Anteil der divergenten Reflexionen der optischen Strahlung 11 an der Grenzfläche Substrat 3 zu Träger 5 auf die Rückseite der photoaktiven Schicht 2 treffen. Hierdurch werden deutlich weniger Ladungsträger in der photoaktiven Schicht 2 erzeugt, und THz-Echo-Pulse können effektiv minimiert werden. Abgesehen von der Anordnung der Teilstrukturen 7, 8 relativ zur photoaktiven Schicht 2 und die Ausführung der photoaktiven Schicht 2 als Mesa-Struktur hat die in der Fig. 7 gezeigte Antenne 16 die gleichen Eigenschaften wie die Antenne der Fig. 6.

In der Fig. 8 ist eine Antenne 16 gezeigt, welche zusätzlich zur Antenne 16 der Fig. 6 eine Linse 13 für THz-Strahlung 12 aufweist. Die Linse 13 koppelt die THz-Strahlung 12 aus der Antenne 16 aus und ist im Ausführungsbeispiel der Fig. 8 als plankonvexe Linse, insbesondere eine hemisphärische Linse oder eine hyperhemisphärische Linse ausgebildet. Die Linse 13 ist auf dem Träger 5 befestigt, wobei die plane Seite der Linse 13 mit der zweiten, planen Seite des Trägers 5 verbunden ist. Vorzugsweise ist die Linse 13 aus dem gleichen Material wie der Träger 5 und das Substrat 3 hergestellt, im gezeigten Ausführungsbeispiel also aus Si. In diesem Fall kann die Linse 13 beispielhaft mittels eines Presskontakts mit dem Träger 5 verbunden sein und direkt an den Träger 5 angrenzen. Alternativ können auch andere Materialien für die Linse 13 verwendet werden. Denkbar wären zum Beispiel Polymermaterialien, wie Polymethylpenten. In diesem Fall könnte die Linse 13 mittels einer dritten haftvermittelnden Schicht flächig und bündig mit dem Träger 5 verbunden werden, beispielsweise mittels einer Klebeschicht aus BCB. Eine Linsendicke beträgt vorzugsweise wenigstens 2 mm, insbesondere wenigstens 3 mm. Die Linse 13 kann eine gleiche Dicke wie der Träger 5 haben.

In einer alternativen Ausführungsform kann die Linse den Träger bilden. Diese Ausführungsform der Antenne 16 ist in der Fig. 9 gezeigt. Hier ist das Substrat 3 also direkt auf der Linse 14 befestigt, ohne dass ein zusätzlicher Träger benötigt wird. Die Linse 14 kann an das Substrat 3 angrenzen oder es kann sich eine vierte haftvermittelnde Schicht zwischen der Linse 14 und dem Substrat 13 angeordnet sein, welche die plane Seite der Linse 14 und das Substrat 3 flächig und bündig mit einander verbindet. Die Linse 14 ist aus dem gleichen Material wie das Substrat 3 hergestellt. Für weitere Merkmale der Linse 14 sei auf die obige Linse 13 verwiesen.

In der Antenne 16 der Fig. 9 sind die photoaktive Schicht 2 und die Metallstrukturen 7, 8 des Antennenleiters 6 in ähnlicher Weise aufgebaut, wie in der Antenne der Fig. 7. Es ist jedoch klar, dass alternativ auch auf den Aufbau der photoaktiven Schicht 2 und der Metallstrukturen 7, 8 der Fig. 6 zurückgegriffen kann.

Die in der Fig. 10 gezeigte Antenne 16 hat einen ähnlichen Aufbau wie die Antenne der Fig. 8 und weicht lediglich in Bezug auf die Anordnung der Metallstrukturen 7, 8 von der Antenne der Fig. 8 ab. Die Metallstrukturen 7, 8 des Antennenleiters 6 der Fig. 10 sind auf einer dem Substrat 3 zugewandten Seite der photoaktiven Schicht 2 angeordnet, während sie in der Fig. 6 auf einer dem Substrat 3 abgewandten Seite der photoaktiven Schicht angeordnet sind. In der Fig. 10 ist angedeutet, dass die erste haftvermittelnde Schicht 4 zwischen den Metallstrukturen 7, 8 und dem Substrat 3 angeordnet ist, und die Metallstrukturen 7, 8 flächig mit dem Substrat 3 verbindet. Die erste haftvermittelnde Schicht 4 hat also im Bereich der Metallstrukturen 7, 8 eine verringerte Schichtdicke. Ein Vorteil der in Fig. 10 gezeigten Anordnung ist, dass reflektierte optische Strahlung auf die lichtundurchlässige Metallstrukturen 7, 8 trifft und somit keine freien Ladungsträger in der photoaktiven Schicht 2 erzeugt. Eine dem Substrat 3 abgewandten Seite der photoaktiven Schicht 2 ist komplett beschichtungsfrei und liegt frei an der Umgebungsluft.

Die Antennen 16 der Figuren 6-10 werden bevorzugt in dem Terahertzsystem 20 der Fig. 11 verwendet.

Nachstehend wird ein Verfahren zur Herstellung der Anordnung 1 bzw. zur Herstellung der Antenne 16 beschrieben.

Zunächst wird ein Hilfssubstrat (nicht gezeigt) aus InP bereitgestellt. Danach wird die photoaktive Schicht 2 hergestellt. Die photoaktive Schicht 2 wird durch epitaktisches Wachstum auf dem InP Hilfssubstrat erzeugt. Üblicherweise wird die photoaktive Schicht 2 mittels Molekularstrahlepitaxie bei einer Temperatur von 200 °C bis 450 °C aufgewachsen. Die Temperatur liegt vorzugsweise bei 400 °C. Beim epitaktischen Aufwachen wird die photoaktive Schicht 2 vorzugsweise mit einem Übergangsmetall in einer Konzentration von mindestens 10¹⁸ cm⁻³ dotiert.

Nach dem Herstellen der photoaktiven Schicht 2 kann die dem Hilfssubstrat abgewandte Seite der photoaktiven Schicht vollflächig mit einem Silizium-Wafer mit einem Durchmesser von mindestens 2 Zoll, vorzugsweise mindestens 3 Zoll und einer Waferdicke zwischen 0,2 mm und 1 mm, verbunden werden, wobei für die Verbindung die erste haftvermittelnde Schicht 4 benutzt wird. Der Silizium-Wafer und das Hilfssubstrat befinden sich nun auf gegenüberliegenden Seiten der photoaktiven Schicht 2. Anschließend wird das Hilfssubstrat vollständig entfernt, vorzugsweise durch chemisches Ätzen. Alternativ kann das Hilfssubstrat auch mechanisch entfernt werden.

In einem zusätzlichen Schritt wird der Antennenleiter 6 mit der photoaktiven Schicht 2 kontaktiert. Der Antennenleiter 6 mit der ersten Teilstruktur 7 und der zweiten Teilstruktur 8 wird derart auf die photoaktive Schicht 2 aufgebracht, dass die beiden Teilstrukturen 7, 8 voneinander beabstandet sind und die photoaktive Schicht 2 kontaktieren. Das Aufbringen des Antennenleiters 6 erfolgt vorzugsweise in einem sogenannten Lift-Off-Prozess mittels Aufdampfens oder Sputterns von Metall.

Das Aufbringen des Antennenleiters 6 kann hierbei unmittelbar vor dem Verbinden der photoaktiven Schicht 2 mit dem Substrat 3 (also vor dem Entfernen des Hilfssubstrats) oder erst nach dem Entfernen des Hilfssubstrats erfolgen.

Für die Herstellung der in der Figuren 7 und 9 gezeigten Mesa-Strukturen der photoaktiven Schicht 2 kann die photoaktive Schicht 2 nach dem Entfernen des Hilfssubstrats bereichsweise weggeätzt werden, in der Regel durch nasschemische Ätzprozesse und Trockenätzprozesse. Hiernach können die Metallstrukturen 7, 8 wie oben beschrieben aufgebracht werden. Alternativ kann die Mesa-Struktur der photoaktiven Schicht 2 vor dem Verbinden der photoaktiven Schicht 2 mit dem Silizium-Wafer hergestellt werden. Danach werden die Metallstrukturen 7, 8 durch Aufdampfen oder Sputtern auf die photoaktive Schicht 2 aufgebracht. Anschließend wird die erste haftvermittelnde Schicht 4 auf die Metallstrukturen 7, 8 und die photoaktive Schicht 2 aufgetragen. Dann wird der Silizium-Wafer mit der photoaktiven Schicht 2 über die Schicht 4 verbunden. In einem weiteren Schritt wird das Hilfssubstrat entfernt, vorzugsweise vollständig entfernt.

Optional kann eine Oberflächenpassivierung, beispielsweise aus Siliziumnitrid oder Siliziumoxid, auf die photoaktive Schicht 2 und/oder die metallischen Teilstrukturen 7, 8 aufgebracht werden.

Nachdem die photoaktive Schicht 2, der Wafer, die haftvermittelnde Schicht 4 und die Metallstrukturen 7, 8 relativ zueinander angeordnet wurden, kann der Silizium-Wafer derart zugeschnitten werden, dass eine Vielzahl von Chips geformt werden, die jeweils ein Substrat 3 aus Si, die haftvermittelnde Schicht 4, die photoaktive Schicht 2 und die Metallstrukturen 7, 8 aufweisen. Der Si-Wafer wird also für die Herstellung einer Vielzahl von Substraten 3 benutzt. Selbstverständlich kann anstelle des Wafers auch das als Chip ausgebildete Substrat 3 bereits am Anfang des Verfahrens genutzt werden.

Danach wird das Substrat 3 auf dem Träger 5 oder auf der als Träger ausgebildeten Linse 14 befestigt. Gegebenenfalls wird anschließend noch die Linse 13 mit dem Träger 5 verbunden.

Das beschriebene Verfahren eignet sich insbesondere zur Herstellung der oben beschriebenen Anordnung 1 und der beschriebenen Antenne 16 der Figuren 6-10. Merkmale die nur in Bezug auf die Anordnung und die Antenne genannt werden können auch für das Verfahren beansprucht werden und andersherum.

### Bezugszeichenliste:

- 1: Anordnung für eine THz-Antenne
- 2: photoaktive Schicht
- 3: Substrat
- 4: haftvermittelnde Schicht
- 5: Träger
- 6: Antennenleiter
- 7: Metallstruktur
- 8: Metallstruktur
- 9: Lücke
- 10: plane Grenzfläche
- 11: fs-Laserpuls
- 12: THz-Puls
- 13: Linse
- 14: Linse
- 15: Laser
- 16: Sendeantenne
- 17: Empfängerantenne
- 18: Lichtleitfaser
- 19: Verzögerungsschaltung
- 20: Terahertzsystem
- 21: photoaktive Schicht
- 22: Substrat
- 23: Metallstruktur
- 24: Metallstruktur
- 25: Träger
- 26: Grenzfläche
- 27: Echopuls
- 28: Strahteiler
- 29: Probe
- 30: THz-Sender
- 31: THz-Empfänger
- 32: Lackschicht
- 33: Metallträger
- 34: THz-Reflexionsmuster
- 35: Replika
- 36: Probe

## Patentansprüche

1. Anordnung (1) für eine Antenne (16, 17) zum Erzeugen oder Empfangen von Terahertz-Strahlung (12), umfassend
- eine photoaktive Schicht (2), welche durch optische Strahlung (11) im Bereich 1200 nm bis 1700 nm aktivierbar ist,
- ein für die optische Strahlung (11) transparentes Substrat (3), auf dem die photoaktive Schicht (2) befestigt ist,
- einen für die optische Strahlung (11) transparenten Träger (5), wobei das Substrat (3) auf dem Träger (5) befestigt ist und zwischen der photoaktiven Schicht (2) und dem Träger (5) angeordnet ist,
**dadurch gekennzeichnet,**
**dass** das Substrat (3) und der Träger (5) aus einem gleichen Material hergestellt sind,
wobei eine erste haftvermittelnde Schicht (4) zwischen der photoaktiven Schicht (2) und dem Substrat (3) angeordnet ist und beide flächig miteinander verbindet,
und wobei die erste haftvermittelnde Schicht (4) eine Schichtdicke von höchstens 5 µm aufweist.

2. Anordnung (1) nach Anspruch 1, wobei
- die photoaktive Schicht (2) eine Schichtdicke von höchstens 10 µm, vorzugsweise mindestens 0,5 µm aufweist und/oder
- das Substrat (3) eine Substratdicke von höchstens 1 mm, vorzugsweise mindestens 0,2 mm aufweist und/oder
- der Träger (5) eine Trägerdicke von mindestens 3 mm, vorzugsweise mindestens 5 mm aufweist.

3. Anordnung (1) nach einem der vorstehenden Ansprüche,
wobei der Träger (5) und das Substrat (3) aus Silizium hergestellt sind und/oder
wobei die photoaktive Schicht (2) zumindest überwiegend aus InGaAs, InAIAs, InGaAsP, InGaAlAs, InGaAlAsP und/oder GaAlAs hergestellt ist und vorzugsweise mit einem Übergangsmetall dotiert ist.

4. Anordnung (1) nach einem der vorstehenden Ansprüche, wobei das Substrat (3) als planparallele Platte und/oder der Träger (5) als planparalleler Körper ausgeführt sind.

5. Anordnung (1) nach einem der vorstehenden Ansprüche, umfassend eine Linse (13) für die Terahertzstrahlung (12), vorzugsweise eine plankonvexe Linse, hemisphärische Linse oder eine hyperhemisphärische Linse, wobei die Linse (13) auf dem Träger (5) befestigt ist oder wobei die Linse (13) den Träger (5) bildet.

6. Anordnung (1) nach einem der vorstehenden Ansprüche, wobei eine dem Substrat (3) abgewandte Seite der photoaktiven Schicht (2) zumindest bereichsweise beschichtungsfrei ist und vorzugsweise an der Umgebungsluft freiliegt.

7. Antenne (16, 17) zum Erzeugen oder Empfangen von Terahertz-Strahlung (12), umfassend eine Anordnung (1) nach einem der vorstehenden Ansprüche und einen Antennenleiter (6) mit einer ersten Teilstruktur (7) und einer zweiten Teilstruktur (8), wobei die erste Teilstruktur (7) und die zweite Teilstruktur (8) durch eine Lücke (9) voneinander beabstandet sind und die photoaktive Schicht (2) kontaktieren.

8. Antenne (16, 17) nach Anspruch 7, wobei der Antennenleiter (6) auf einer dem Substrat (3) abgewandten oder zugewandten Seite der photoaktiven Schicht (2) angeordnet ist.

9. Antenne (16, 17) nach Anspruch 7, wobei die erste Teilstruktur (7) und die zweite Teilstruktur (8) auf dem Substrat (3) seitlich neben der photoaktiven Schicht (2) angeordnet sind und die photoaktive Schicht (2) zwischen den beiden Strukturen (7, 8) angeordnet ist.

10. Antenne (16, 17) nach Anspruch 9, wobei die photoaktive Schicht (2) eine Grundfläche von höchstens 1 mm², vorzugsweise höchstens 0,1 mm², insbesondere höchstens 0,01 mm² aufweist.

11. Terahertzsystem (20) zum Erzeugen und kohärenten Detektieren von Terahertzstrahlung (12), umfassend eine Laserlichtquelle (15) und zwei jeweils optisch mit der Laserlichtquelle gekoppelte und durch optische Strahlung (11) dieser Laserlichtquelle aktivierbare THz-Antennen (16, 17), von denen eine erste als Sendeantenne (16) und eine zweite als Empfängerantenne (17) dient, wobei die Sendeantenne (16) und/oder die Empfängerantenne (17) jeweils eine Antenne nach einem der Ansprüche 8 bis 10 umfassen.

12. Terahertzsystem (20) nach Anspruch 11, wobei die optische Strahlung (11) der Laserlichtquelle (15) eine Wellenlänge von wenigstens 1200 nm und/oder höchstens 1700 nm hat.

13. Verfahren zum Herstellen einer Anordnung (1) für eine Antenne (16, 17) zum Erzeugen oder Empfangen von Terahertz-Strahlung (12), umfassend die Schritte:
- Herstellen einer photoaktiven Schicht (2) auf einem Hilfssubstrat, welches zumindest überwiegend aus InP gebildet ist,
- flächiges Verbinden der photoaktiven Schicht (2) mit einem Substrat (3) mittels einer ersten haftvermittelnden Schicht (4), welche eine Schichtdicke von höchstens 5 µm aufweist,
- Entfernen des Hilfssubstrats, vorzugsweise durch chemisches Ätzen, und
- Befestigen des Substrats (3) auf einem Träger (5), sodass das Substrat (3) zwischen der photoaktiven Schicht (2) und dem Träger (5) angeordnet ist,
wobei die photoaktive Schicht (2) durch optische Strahlung (11) im Bereich 1200 nm bis 1700 nm aktivierbar ist, wobei das Substrat (3) und der Träger (5) aus einem gleichen Material hergestellt sind und transparent für die optische Strahlung (11) sind.

14. Verfahren nach Anspruch 13, wobei die photoaktive Schicht (2) mittels Molekularstrahlepitaxie bei einer Temperatur von 200 °C bis 450 °C aufgewachsen wird und/oder wobei die photoaktive Schicht epitaktisch aufgewachsen wird und mit einem Übergangsmetall in einer Konzentration von mindestens 10¹⁸ cm⁻³ dotiert ist.

15. Verfahren nach einem der Ansprüche 13 oder 14, mit dem zusätzlichen Schritt:
- Aufbringen eines Antennenleiters (6) mit einer ersten Teilstruktur (7) und einer zweiten Teilstruktur (8) auf die photoaktive Schicht (2) derart, dass die beiden Teilstrukturen (7, 8) voneinander beabstandet sind und die photoaktive Schicht (2) kontaktieren,
wobei der Schritt des Aufbringens des Antennenleiters (6) auf die photoaktive Schicht (2)
- vor dem Verbinden der photoaktiven Schicht (2) mit dem Substrat (3) oder
- nach dem Entfernen des Hilfssubstrats
erfolgt.
